# EUROPEAN PATENT SPECIFICATION

(11) **EP 0 860 103 B1**
(45) Date of publication and mention of the grant of the patent: **18.08.1999**
(21) Application number: 96937509.6
(22) Date of filing: 07.11.1996
(51) Int. Cl.: H05K 13/08

(54) **COMPONENT MOUNTING APPARATUS AND METHOD**
EINRICHTUNG UND VERFAHREN ZUR MONTAGE VON BAUTEILEN
SYSTEME ET PROCEDE POUR LE MONTAGE DE COMPOSANTS

(30) Priority: 09.11.1995 JP 29073195; 20.11.1995 JP 30094795; 30.11.1995 JP 31219095
(43) Date of publication of application: 26.08.1998
(73) Proprietor: MATSUSHITA ELECTRIC INDUSTRIAL CO., LTD., Kadoma-shi, Osaka 571-0050 (JP)
(72) Inventor: KURATA, Hiroaki, Yamanashi 400-01 (JP); HATTORI, Yoshiyuki, Yamanashi 400 (JP); MORIMOTO, Kenji, Yamanashi 400 (JP); NONAKA, Satoshi, Yamanashi 400-06 (JP); AZUMA, Yasuhiro, Osaka 589 (JP)
(74) Representative: Eisenführ, Speiser & Partner
(86) International application number: JP9603246
(87) International publication number: WO9717827

(56) References cited:
- EP-A- 0 600 663
- PROCEEDINGS OF THE INTERNATIONAL SEMICONDUCTOR MANUFACTURING SCIENC SYMPOSIUM (ISMSS), SAN FRANCISCO, JUNE 15 - 16, 1992, no. -, 15 June 1992, INSTITUTE OF ELECTRICAL AND ELECTRONICS ENGINEERS, pages 90-93, XP000336219 RAM S N ET AL: "PAPERLESS MANUFACTURING FOR IC ASSEMBLY"
- PATENT ABSTRACTS OF JAPAN vol. 018, no. 500 (P-1802), 19 September 1994 & JP 06 167956 A (SHARP CORP), 14 June 1994,

## Description

### TECHNICAL FIELD

The present invention relates to component mounting method and apparatus for mounting components onto members such as boards, and more specifically, relates to screen control method and apparatus used in the component mounting method and apparatus for protecting monitor screens in personal computers and component mounting apparatuses. The present invention also relates to a component mounting method for dynamically customizing operation menus for the electronic component mounting apparatus, and relates to an electronic component mounting apparatus which is provided with the method. The present invention also relates to component mounting method and apparatus which are capable of inputting positional data onto an operating screen of a computer thereof.

### BACKGROUND ART

The screen saver function is implemented for the purposes of preventing the burn-in of pixels of the monitor screen and holding the quality of the pixels, by erasing the image on the monitor screen or by displaying moving graphics and characters on the screen. For component mounting apparatuses, because almost no operations from the monitor screen are executed during the production, the screen saver function is required in particular.

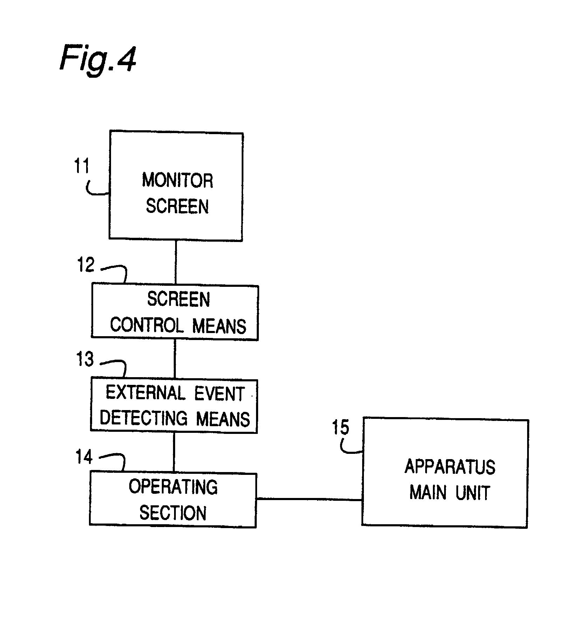

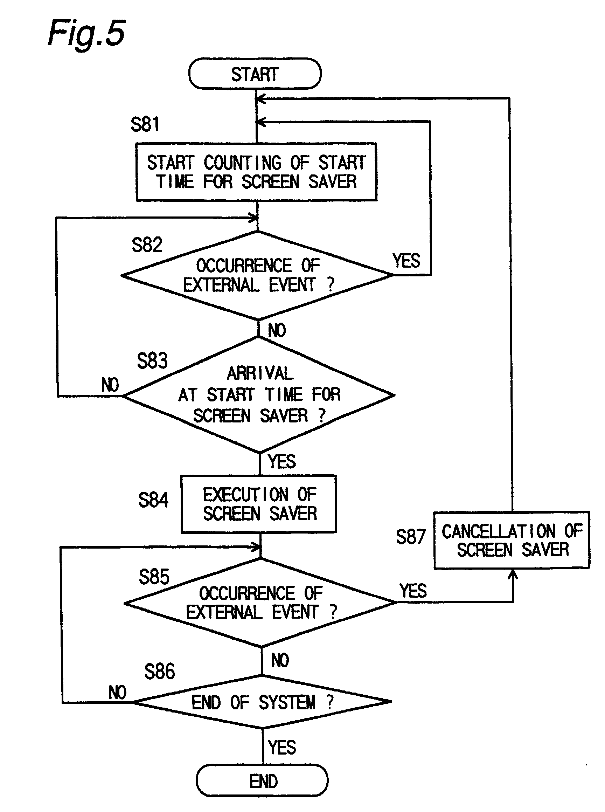

The conventional screen control method is described below with reference to Figs. 4 and 5.

In Fig. 4, reference numeral 11 denotes a monitor screen, 12 denotes screen control means for executing the screen saver function, and 13 denotes external event detecting means for canceling the screen saver function. Reference numeral 14 denotes an operating section for operating the apparatus, and 15 denotes an apparatus main unit.

If no operation is executed by the operating section 14 during a predetermined time period, the screen control means 12 executes the screen saver function on the monitor screen 11 to erase the screen. When a key input from the operating section 14 or a depression of the screen saver function canceling key or the like is effected, the external event detecting means 13, upon detecting it, requests the screen control means 12 to cancel the screen saver function, restoring the screen of the monitor screen 11 to its original state (See "Windows Function Guide", pages 203-204, published by Microsoft Corporation on September 20, 1993).

The flow chart of the above action (operation) is shown in Fig. 5. That is, a start time for screen saver is counted at step S81, and then it is decided at step S82 whether or not an external event is occurred. If so, the program returns to step S81. If not, it is decided at step S83 whether or not the counting is arrived at a start time for screen saver. If not, the program returns to step S82. If so, the screen saver is executed at step S84. Then, it is decided at step S85 whether or not an external event is occurred. If so, the screen saver is canceled at step S87 and then, the program returns to step S81. If not at step S85, it is decided at step S86 whether or not the operation of the apparatus is terminated. If not, the program returns to step S85. If so, the program is ended.

However, with the above arrangement, the screen saver function could be canceled only by an input from the operating section 14. As a result, there has been an issue that even when an abnormality has occurred to the apparatus main unit 15, the abnormality could not be known immediately through the monitor screen 11.

Also, depending on the action mode of the apparatus or the contents of work, there are some cases where no operation is effected during a certain time period but the screen monitoring is required. In such a case, the screen saver function, if activated, needs to be canceled by effecting a key press or other operation each time it occurs. This would result in laborious operation, causing a deterioration of the workability, as another issue.

Conventionally, operation menus have been fixedly configured, based on a function tree defined previously by the manufacturer, in which each menu has been positioned unchanged at all times.

Now referring to the appended drawings, a structure of conventional operation menus mentioned above will be described.

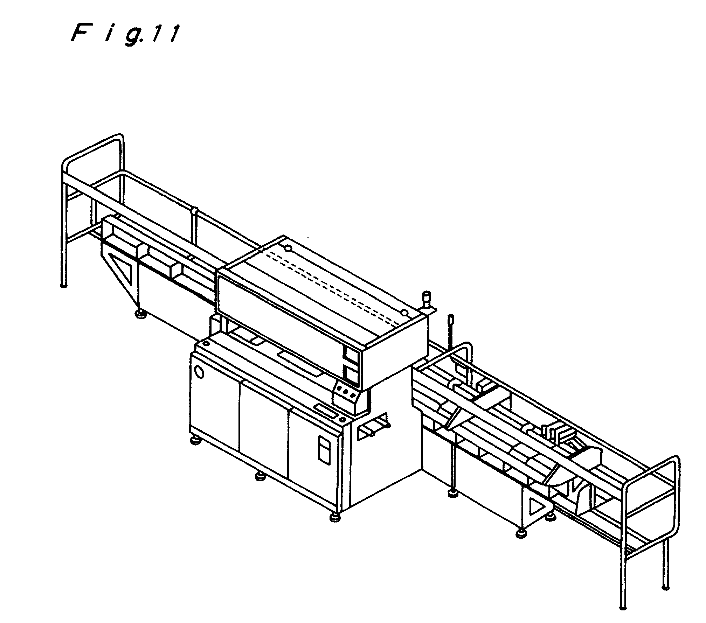

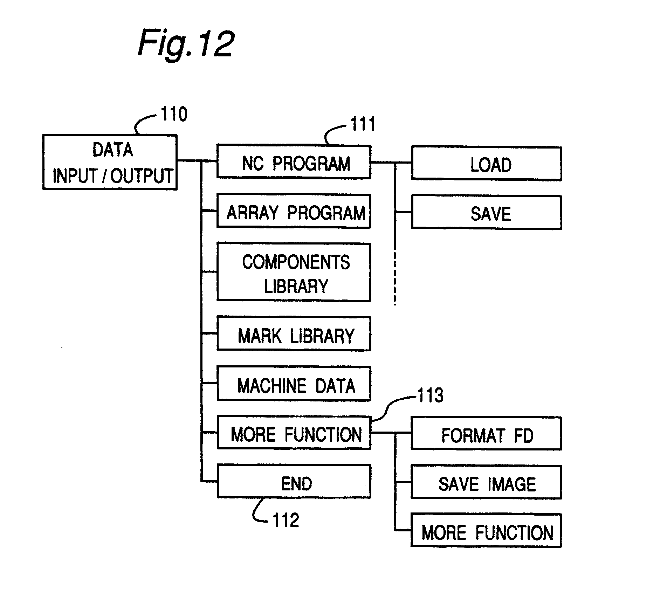

Fig. 11 illustrates an electronic component mounting apparatus which is provided with an operating system. Fig. 12 illustrates an example of the function tree structure of an electronic component mounting apparatus. In Fig. 12, a menu 110 is on an upper-order hierarchy of a menu 111 and of other menus on the same hierarchy as the menu 111, where selecting the menu 110 permits the menu 111 or other menus to be selected. A return to a menu of an upper-order hierarchy from a lower-order hierarchy is done by choosing a particular menu, such as a menu 112, so defined within the lower-order hierarchy. A menu 113 is a special menu which is provided in the case where a large number of menus are on the same hierarchy. The number of menus that can be displayed simultaneously within one screen is limited by the layout of the operating screen, the hardware configuration of the input device, and the like. Accordingly, when the number of the menus to be arranged on the same hierarchy exceeds this limit due to the function tree structure, the menus are divided into a plurality of groups and special menus for switching among the groups is newly provided to change over the group of menus to be displayed on the screen (See "OPERATING INSTRUCTIONS Panasert MPA-III", page 1-41/42, published by Matsushita Electric Industrial Co., Ltd. on September 18, 1992).

In the operation menus arranged as above, when an objective menu is located at a terminal end of the function tree, the user has to trace the menus one by one from upper-order to lower-order hierarchies, i.e., from broader to narrower terms. Besides, in a selection within each hierarchy, the user has to select a menu pertinent to the purpose of an operation from among a plurality of alternatives with the clue of the menu titles.

Generally, the electronic component mounting apparatus is required to have a large number of functions in controlling the apparatus, managing and editing data with which the apparatus deals, and the like, so that the operation menus are large-scaled and complicated. Accordingly, to quickly know the location of a menu that the user aims is one of the important factors that directly affect the apparatus productivity. In the conventional arrangement described above, however, the menus are fixedly positioned, and therefore, when a menu with a lower operational frequency is arranged in a higher order than a menu with a higher operational frequency depending on the structure of the function tree, each menu selection requires an additional procedure for seeking the intended menu from an upper-order position to a lower-order position, resulting in poor operability as an issue.

Moreover, in an operation menu structure where a large number of menus are on the same hierarchy like the menu 13, the menus even on the same hierarchy have to be divided into the upper-order hierarchy and the low-order hierarchy consequently. Thus, in this structure, the number of procedures required for selecting a menu on the low-order hierarchy is necessarily one greater than the number of procedures required for selecting a menu on the upper-order hierarchy. This would result in further complicated structure of operation menus as another issue.

A characteristic of the operation of electronic component mounting apparatus is that the frequency of use of a menu varies dynamically because different menus are used depending on the operated conditions of the apparatus, such as those in which the apparatus is under production, under a changeover of product items, and under maintenance. For example, it is expected that whereas the production management information concerning product items is frequently referred to under production, the reference to data such as reference to and setting of apparatus data is more frequent than the reference to the production management information during maintenance. In many cases, actually, an operation involving a plurality of menus is required, such as when data reference is made under the production, and the menus are repetitively used by turns, so that those menus involved are necessarily selected more frequently than the other menus. In the case where such menus of higher selectional frequency are consequently arranged in lower orders than menus of lower selectional frequency, the result would be such that increased procedures are required for menu selection by the user.

The operational frequency of a menu also depends on the way in which the user runs the apparatus. Some users runs the apparatus in the way that operations such as the input and output of data and the editing of data are collectively assigned to the host while only the setting of apparatus data is the main part of the operations using the operation menus of the apparatus. Accordingly, it is difficult to arrange the fixed operation menus provided by the manufacturer so that the ways in which all the users run the apparatus are satisfied.

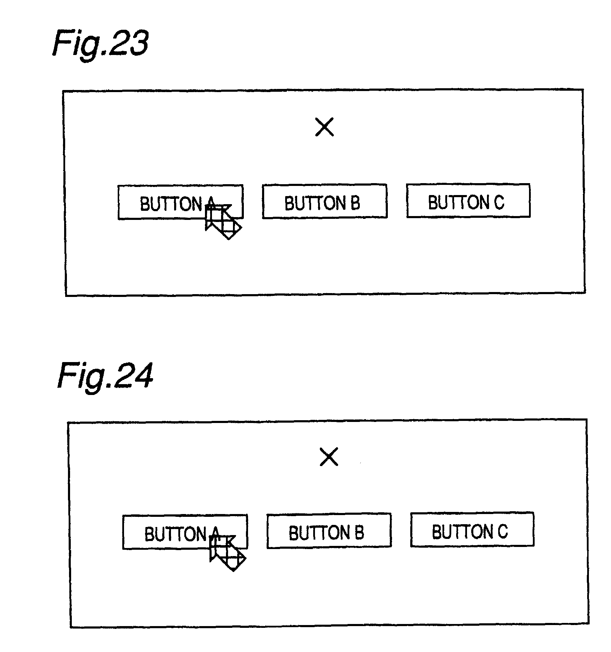

On the other hand, conventionally, in designating a position on an operating screen of a computer by using an input device such as a mouse, track ball or joy stick, a cursor is moved to the objective position, as shown in Fig. 23, by manipulating the mouse or the like. Otherwise, as shown in Fig. 24, the cursor is automatically moved to a default position inputted previously (See "COMPUTER DICTIONARY", page 89, published by Microsoft Press on 1991).

The conventional input methods, however, have had some issues. For example, it would take much time for an operator who is not accustomed to manipulate the mouse or track ball, to move the cursor to the objective position, and such an operator would fail to move the cursor to the objective position just as he or she wants. In some cases, the operation by a keyboard would be rather faster, so that the operator would use both the input device, such as a mouse, and the keyboard, resulting in complicated operation.

### DISCLOSURE OF THE INVENTION

Accordingly, an object of the present invention is to provide component mounting method and apparatus in which a screen saver function is automatically canceled as it is necessary, for example when an abnormality has occurred to its apparatus main unit or when an action mode needs monitoring. An object of the present invention is also to provide component mounting method and apparatus in which operation menus are customized optimally for a user by dynamically changing over the operation menus. An object of the present invention is to provide method and apparatus for moving a cursor to an objective position without designating the position in detail with an input device such as a mouse or track ball.

In accomplishing these and other aspects, according to a first aspect of the present invention, there is provided a method for mounting components onto a member, comprising executing an operation by an operating section through a monitor screen in which a screen control method is used,
the screen control method comprising steps of:
providing a screen control means (2) for executing a screen saver function on the monitor screen when no operation is effected on the operating section during a preset time period;
providing an external event detecting means (3) for canceling the screen saver function upon detection of an event derived from the operating section; and
providing an internal event detecting means (6) for canceling the screen saver function upon detection of an event derived from the apparatus other than the operating section.

According to a second aspect of the present invention, there is provided an apparatus for mounting components onto a member, comprising a screen control apparatus,
the screen control apparatus comprising:
a monitor screen;
an operating section for executing an operation through the monitor screen;
a screen control means for executing a screen saver function on the monitor screen;
an external event detecting means for canceling the screen saver function upon detection of an event derived from the operating section; and
an internal event detecting means for canceling the screen saver function upon detection of an event derived from the apparatus other than the operating section.

Advantageous embodiments of the present invention are defined in the dependent claims.

With the arrangement, the screen control method and apparatus allow the screen saver function to be executed only when it is truly desired to display nothing on the monitor screen, by which the quality of the monitor screen is maintained.

Further, the screen saver function can be canceled upon detection of an error or a warning caused in the apparatus or executing the method as an internal event, so that abnormality can be known immediately by viewing the monitor screen.

Further, since the screen saver function is not executed on the monitor screen in accordance with an operational mode of the component mounting apparatus or method, the monitor screen can be monitored even if no operation is effected during a certain time period, in accordance with the operational mode.

According to a seventh aspect of the present invention, there is provided the component mounting method as defined in the first aspect, comprising a method for customizing operation menus of an electronic component mounting apparatus comprising a screen for displaying operation menus of an electronic component mounting apparatus to a user,
the method comprising steps of:
selecting an operation menu out of the operation menus;
dynamically rearranging an order in which the operation menus are displayed on the screen, according to frequencies of selection of the operation menus by the user so that an operation menu having the higher frequency of selection is moved to a position that is easier to select.

According to an eighth aspect of the present invention, there is provided the component mounting method, as defined in the first aspect, comprising a method for customizing operation menus of an electronic component mounting apparatus,
the method comprising steps of:
selecting an operation menu out of the operation menus;
dynamically reshuffling, when a number of operation menus contained in a menu group of a same hierarchy which belongs to a common upper-order operation menu exceeds a maximum number of operation menus that can be displayed within a screen, groups of the operation menus according to operational frequencies of the menus so that operation menus having relatively high operational frequencies are included in a group of operation menus that is first displayed, and are thereby preferentially displayed.

According to a ninth aspect of the present invention, there is provided the electronic component mounting apparatus as defined in the fourth aspect, wherein the apparatus customizes the operation menus of the apparatus,
the apparatus further comprising an input device for selecting an operation menu out of the operation menus,
wherein the screen displays the operation menus, and the screen control means dynamically rearranges an order in which the operation menus are displayed on the screen, according to frequencies of selection of the operation menus so that an operation menu having the higher frequency of selection is moved to a position that is easier to select.

According to a tenth aspect of the present invention, there is provided the component mounting apparatus as defined in the fourth aspect, wherein the apparatus customizes the operation menus of the apparatus,
the apparatus further comprising an input device for selecting an operation menu out of the operation menus,
wherein the screen displays the operation menus, and the screen control means dynamically reshuffles, when a number of operation menus contained in a menu group of a same hierarchy which belongs to a common upper-order operation menu exceeds a maximum number of operation menus that can be displayed within the screen, groups of the operation menus according to operational frequencies of the menus so that operation menus having relatively high operational frequencies are included in a group of operation menus that is first displayed, and are thereby preferentially displayed.

With the method and apparatus of the seventh through tenth aspects arranged as above for customizing menus according to the operational frequency, the operational frequency of the user can be obtained, for example, from an input device with which the user selects the menu out of the operation menus of the electronic component mounting apparatus, and an order in which the operation menus are displayed on the screen is dynamically rearranged according to frequencies of selection of the operation menus by the user so that an operation menu having the higher frequency of selection is moved to a position that is the easier to select.

According to an eleventh aspect of the present invention, there is provided the component mounting method as defined in the first aspect, comprising a data input method for a computer using an input device,
the method comprising steps of:
in a process of repositioning an input cursor for designation of a position, storing a current cursor position and a cursor position inputted from the input device;
calculating a cursor moving direction based on both the current cursor position and the cursor position; and
moving the cursor to an input-waiting position based on the calculated cursor moving direction and positions of input object candidates, even without an input of detailed positional designation.

According to a twelfth aspect of the present invention, there is provided the component mounting method as defined in the eleventh aspect, further comprising a step of storing a cursor moving velocity in addition to the cursor moving direction calculated from the current cursor position and the inputted cursor position, wherein the cursor is moved to the input-waiting position based on the calculated cursor moving direction, the cursor moving velocity, and the positions of input object candidates even without an input of detailed positional designation.

According to a thirteenth aspect of the present invention, there is provided the component mounting apparatus as defined in the fourth aspect, further comprising:
a current position storing means for storing a current cursor position;
an inputted position storing means for storing a cursor position inputted from an input device;
a moving direction calculating means for calculating a cursor moving direction based on both the current cursor position and the inputted cursor position;
an input object storing means for storing positions of input object candidates; and
a corrected position determining means for moving the cursor to an objective position which an operator purposes, based on the calculated cursor moving direction and the positions of input object candidates.

According to a fourteenth aspect of the present invention, there is provided the component mounting apparatus as claimed in the thirteenth aspect, further comprising: a cursor moving amount differential calculating means for calculating a cursor moving velocity,
wherein the corrected position determining means moves the cursor to the objective position which the operator purposes, based on the calculated cursor moving direction, the cursor moving velocity, and the positions of input object candidates.

With the above arrangements of the eleventh through fourteenth aspects, in positioning the input cursor for designation of a position by data input using the input device such as a mouse or track ball in computer operation, the cursor can be moved to the objective position by a rough input of cursor position even without an input of detailed positional designation.

### BRIEF DESCRIPTION OF DRAWINGS

These and other aspects and features of the present invention will become clear from the following description taken in conjunction with the preferred embodiments thereof with reference to the accompanying drawings, in which:
Fig. 1 is a block diagram showing the arrangement of the screen control section in component mounting method and apparatus according to a first embodiment of the present invention to which a screen control method is applied;
Fig. 2 is a flow chart of the screen control method of the first embodiment;
Fig. 3 is a flow chart of a the screen control method in component mounting method and apparatus according to a second embodiment of the present invention;
Fig. 4 is a block diagram showing the arrangement of the conventional screen control section;
Fig. 5 is a flow chart of the screen control method of Fig. 4;
Fig. 6 is an appearance view of an operating system of a third embodiment of the present invention;
Fig. 7 is a flow chart illustrating the processing procedure of the third embodiment;
Fig. 8 illustrates an operating screen of an embodiment of the third embodiment;
Fig. 9 is a chart illustrating operational frequencies in the third embodiment;
Fig. 10 illustrates a function tree structure of a fourth embodiment of the present invention, in the case where the number of the menus on the same hierarchy which have a common upper-order menu exceeds the maximum number of menus that can be displayed on a screen;
Fig. 11 is an appearance view of an electronic component mounting apparatus to which the third and/or fourth embodiments are applied;
Fig. 12 illustrates an example of a function tree structure of a conventional electronic component mounting apparatus;
Fig. 13 is a flow chart showing an example of the fourth embodiment;
Fig. 14 is a view showing a tree structure of an initial setting state of the menu screen immediately after the apparatus is turned on;
Fig. 15 is a view showing a tree structure during operation before a menu is exchanged;
Fig. 16 is a view showing a tree structure after a menu is exchanged;
Fig. 17 is a system arrangement view of a fifth embodiment of the present invention;
Fig. 18 is a flow chart of the operation in the fifth embodiment;
Figs. 19A, 19B, and 19C are explanatory views showing the operation of the fifth embodiment of the invention;
Figs. 20A, 20B, 20C, and 20D are other explanatory views showing the operation of the fifth embodiment of the invention;
Fig. 21 is a system arrangement view of a sixth embodiment of the invention;
Fig. 22 is a flow chart of the operation in the sixth embodiment of the invention;
Fig. 23 is an explanatory view showing the operation in a conventional method; and
Fig. 24 is another explanatory view showing the operation of the conventional method.

### BEST MODE FOR CARRYING OUT THE INVENTION

Before the description of the present invention proceeds, it is to be noted that like parts are designated by like reference numerals throughout the accompanying drawings.

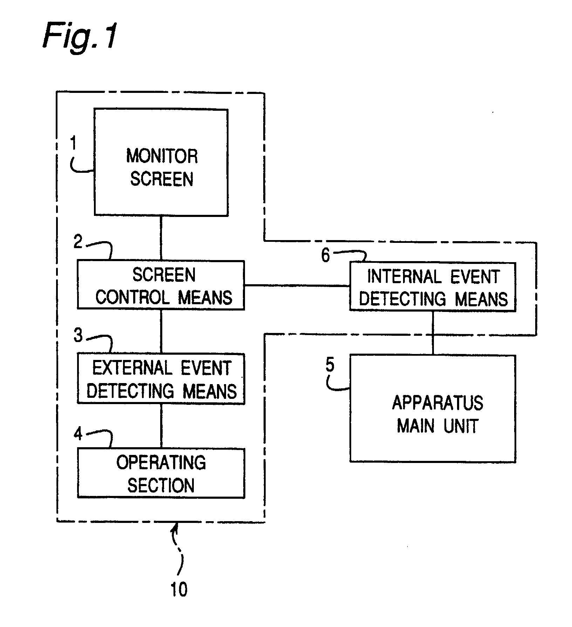

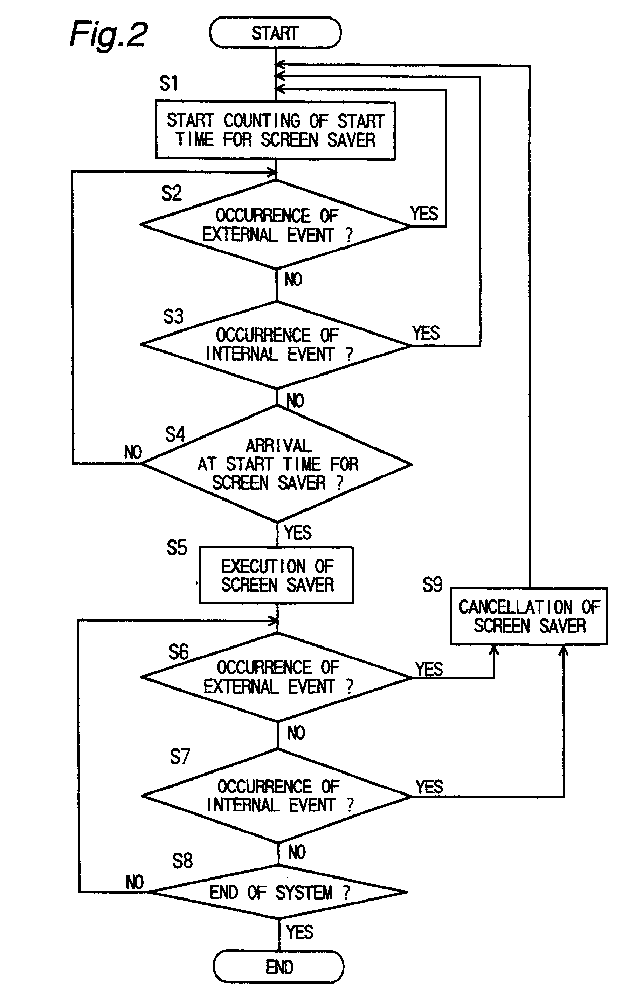

Hereinbelow, an embodiment of the screen control apparatus according to the present invention is described with reference to Figs. 1 and 2.

In Fig. 1, reference numeral 1 denotes a monitor screen, 2 denotes screen control means for executing the screen saver function, and 3 denotes external event detecting means for canceling the screen saver function. Reference numeral 4 denotes an operating section for operating a component mounting apparatus, and 5 denotes an apparatus main unit of the component mounting apparatus. Reference numeral 6 denotes internal event detecting means for canceling the screen saver function upon detection of an event from the apparatus main unit 5.

The action (operation) with the above arrangement is explained with reference to the flow chart of Fig. 2. That is, a start time for screen saver is counted at step S1, and then it is decided at step S2 whether or not an external event is occurred. If so, the program returns to step S1. If not, it is decided at step S3 whether or not an internal event is occurred. If so, the program returns to step S1. If not, it is decided at step S4 whether or not the counting is arrived at a start time for screen saver. If not, the program returns to step S2. If so, the screen saver is executed at step S5. Then, it is decided at step S6 whether or not an external event is occurred. If so, the screen saver is canceled at step S9 and then, the program returns to step S1. If not at step S6, it is decided at step S7 whether or not an internal event is occurred. If so, the screen saver is canceled at step S9 and then, the program returns to step S1. If not at step S7, it is decided at step S8 whether or not the operation of the apparatus is terminated. If not, the program returns to step S86. If so, the program is ended. When no operation is effected during a predetermined time period and no internal event such as an error message from the apparatus main unit 5 occurs, the screen is erased by executing the screen saver function on the monitor screen 1 from the screen control means 2 at steps S1-S5.

Upon a key input from the operating section 4 or a depression of the screen saver function canceling key or the like, the external event detecting means 3 requests the screen control means 2 to cancel the screen saver function, restoring the screen of the monitor screen 1 to the original state at steps S6 and S9.

Also, upon an event such as an error message from the apparatus main unit 5, the internal event detecting means 6 requests the screen control means 2 to cancel the screen saver function, restoring the screen of the monitor screen 1 to the original state at steps S7 and S9.

With the above action, the screen saver function is automatically canceled when the operation of the apparatus or the monitoring of the action is necessary, whereas the screen saver function is executed only when the monitor screen is unnecessary. Thus, the monitor screen 1 can be prevented from burn-in of pixels without deteriorating the workability, so that the quality can be maintained.

Although the screen saver function in the above embodiment has been shown as a method of erasing the screen, it is also possible to display moving graphics or characters on the screen.

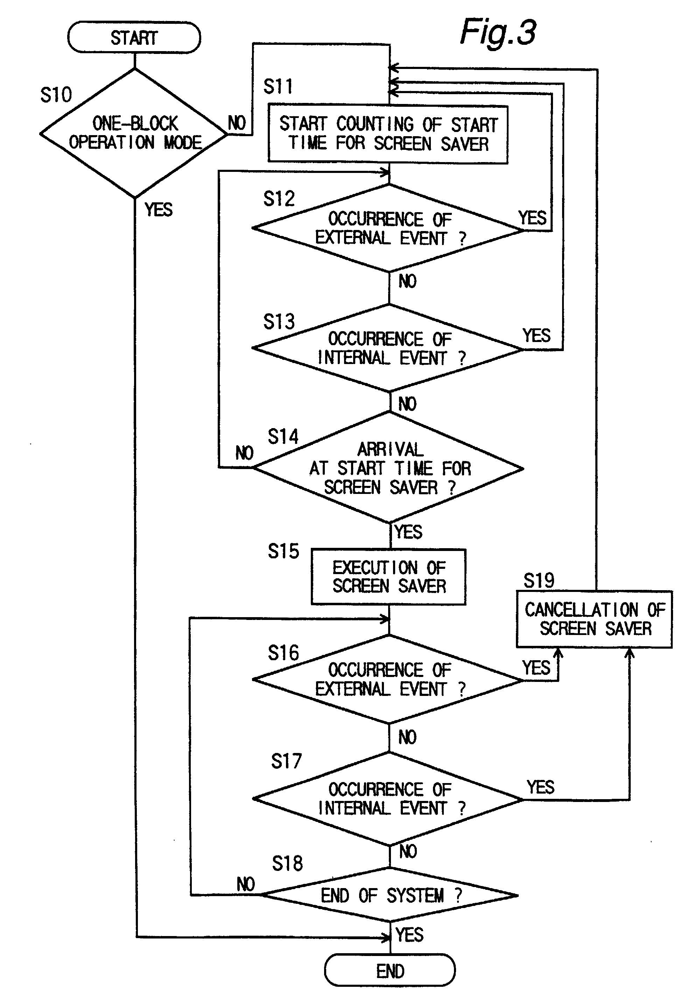

Next, a second embodiment of the present invention is described with reference to Figs. 1 and 3. The apparatus main unit 5 of an electronic component mounting apparatus is so designed as to be able to designate, as its mounting action, a one-block action mode, that is, action adjustment mode, that the action is executed step by step from a component suction action for sucking and holding a component from a component supply section to a component mounting action for mounting the sucked component onto a board for action adjustment, and a continuous action mode, that is, normal action mode, that the action is executed continuously from a component suction action for sucking and holding components from component supply sections to a component mounting action for mounting the sucked components onto boards for continuous production. In the one-block action mode out of these two action modes, the operator operates the mounting apparatus while checking the mounting state in sequence.

In this case, because the operation is not necessarily effected at all times, the screen saver function, when in effect, may be an obstacle to the mounting state checking work. Meanwhile, in the continuous action mode, because the production of electronic component mounting is normally carried out without effecting any operation on the component mounting apparatus, it is not necessary to hold the screen display normally.

The screen control means 2 checks the two action modes at step S10 in Fig. 3, where the screen control means 2 controls in such a way that the screen saver function is nullified for the one-block action mode at step 10, and that the screen saver function is validated for the continuous action mode at steps S10 and S11-S19 which are similar to steps S1-S9 in Fig. 2.

While the operator is operating the component mounting apparatus with the above settings, the screen saver function will not be executed even with an elapse of a predetermined time in the case of the one-block action mode, so that the screen of the monitor screen 1 will not be erased.

As described above, the screen saver function is executed only when it is truly required, by which the operability of the electronic component mounting apparatus can be enhanced.

The above embodiment has been described in the case of one-block action and continuous action modes. However, the present invention may be applied to other actions or modes that the component mounting apparatus has.

According to the screen control method and apparatus in the component mounting method and apparatus of the present invention, as apparent from the above description, when an event from the operating section is detected and/or when an event from the apparatus other than the operating section is detected, the screen saver function is canceled. Therefore, it becomes possible to execute the screen saver function only when it is truly desired to display nothing on the monitor screen, without obstructing the operation of the apparatus or the monitoring of the action. Thus, the burn-in of pixels of the monitor screen can be prevented, and the quality of the monitor screen can be maintained without deteriorating the workability.

Also, the component mounting apparatus is provided with a screen control apparatus comprising internal event detecting means for canceling the screen saver function upon detection of an error or warning as an internal event. With this arrangement, upon eruption of an error or warning, the abnormality can immediately be known by viewing the monitor screen.

Also, the component mounting apparatus is provided with a screen control apparatus comprising screen control means for executing the screen saver function on the monitor screen depending on the action mode of the component mounting apparatus. With this arrangement, the monitor screen can be monitored even if no operation is effected during a certain time period, depending on the action mode of the apparatus or the contents of the work.

Although the screen saver function on the monitor screen is not executed in the action adjustment mode in the second embodiment, the screen saver function on the monitor screen is, in generally, not executed in accordance with an operational mode of the component mounting method/apparatus, such as a non-screen saver mode of the component mounting method/apparatus. The action adjustment mode of the component mounting method is one example of the non-screen saver mode.

Referring to the drawings, a third embodiment of the invention will be described below.

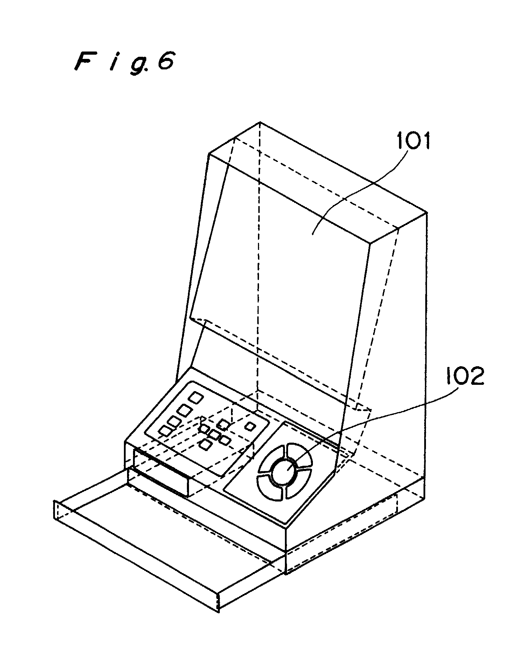

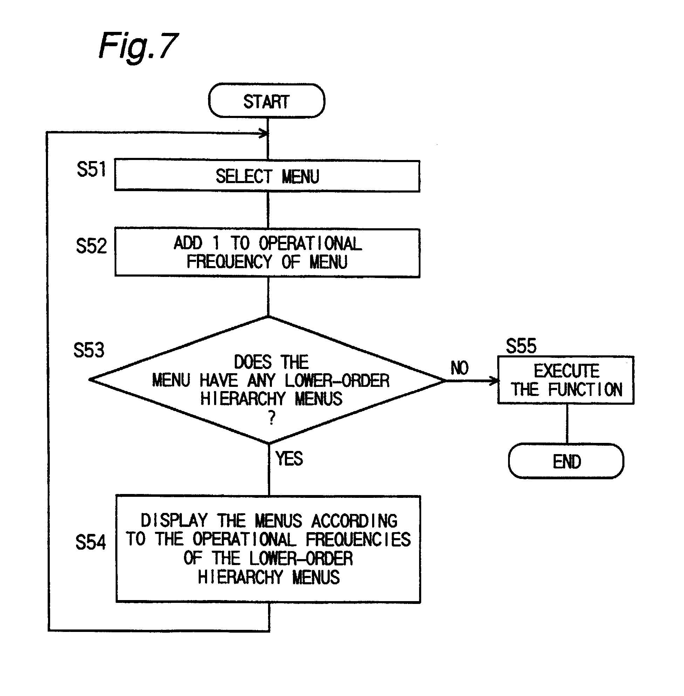

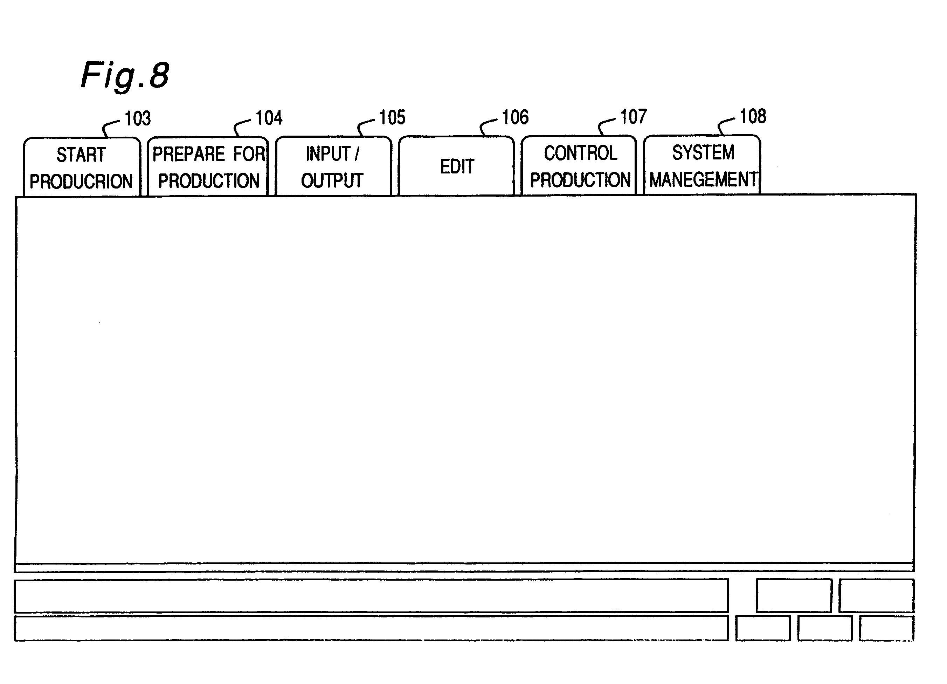

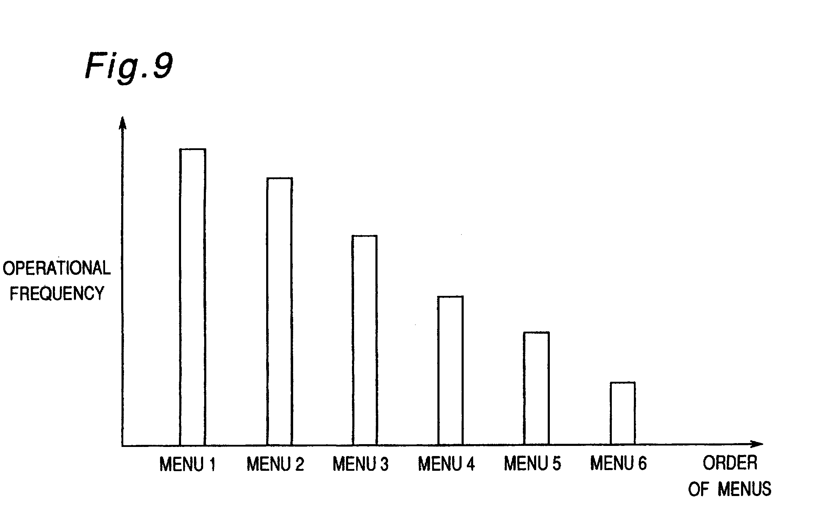

Fig. 6 is an appearance view of an operating system of the third embodiment; Fig. 7 is a flow chart illustrating the processing procedure of the third embodiment; Fig. 8 illustrates an operating screen of the third embodiment; and Fig. 9 is a chart illustrating the operational frequencies which are defined with respect to the menus in Fig. 8. In Fig. 6, reference numeral 101 designates a screen display unit and numeral 102 designates a device for selecting and inputting a menu displayed on the screen display unit 101. In this case, a track ball, a type of pointing device, is employed as the device 102. Fig. 8 illustrates an operating screen displayed on the screen display unit 101, and reference numerals 103, 104, 105, 106, 107, and 108 respectively designate a menu which can be selected. During the selection, a menu is switched over to another menu with the track ball 102.

Referring to Figs. 7, 8, and 9, the action of the operating system arranged as above will be described below.

Initially, a menu selected out of the menus on the same hierarchy which are displayed as shown in Fig. 8 is inputted with the track ball 102. Each menu has the number of times of being selected, i.e. the operational frequency, as its attribute. When a menu is selected at step S51 of Fig. 7, one is added to the operational frequency of the menu at step S52. In Fig. 9, the operational frequencies which are defined with respect to the menus on the same hierarchy are illustrated. In the case that the selected menu has no menus on the lower-order hierarchies at step S53, the function is executed at step S55. In the case that the selected menu has any menus on the lower-order hierarchies at step S53, menus are displayed according to the operational frequencies which the lower-order hierarchy menus have at step S54.

The operational frequencies are compared among a group of menus on the same hierarchy which have the same upper-order menu. A menu which has been selected a greater number of times out of the menu group is defined as having a higher operational frequency, and a menu which has been selected a smaller number of times is defined as having a lower operational frequency. In Fig. 8, it is assumed that a position on the left side of the screen is easier to select. The menus are displayed on the screen from left to right in descending order of operational frequency, based on the latest operational frequencies at all times.

The number of times of selection of a menu assumes a finite value; however, too large a value makes the comparison among the menus meaningless. Therefore, at a timing set arbitrarily by the user (e.g., turning-off of the power of the apparatus, change of the operator etc.), the order of the menus which depend on their operational frequencies at the time point is taken as a basis, and the numbers of times of selection are cleared.

With the third embodiment, as described above, menus 103, 104, 105, 106, 107, and 108 are displayed on the screen from left to right in descending order of operational frequency at all times. Thus, the more highly a menu is expected to be selected at the time of the selection, the nearer to the leftmost position the menu is located.

Referring to the drawings, a fourth embodiment of the invention will be described below.

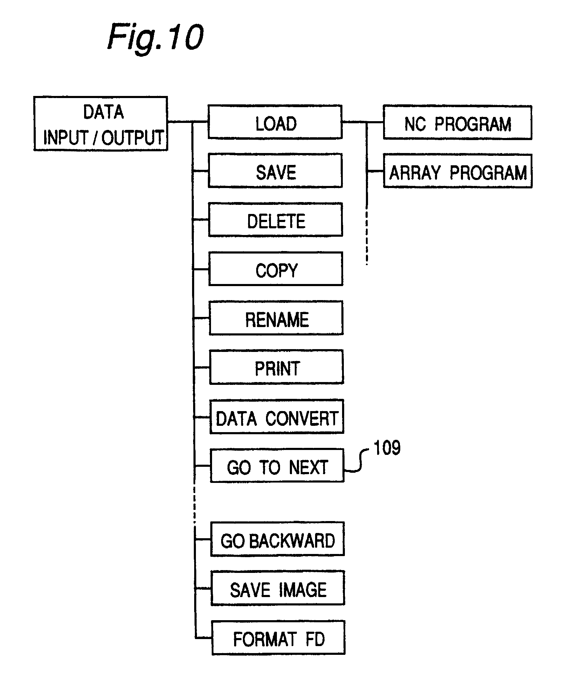

Fig. 10 illustrates a function tree structure in the case where the number of the menus on the same hierarchy which have a common upper-order menu exceeds the maximum number of menus that can be displayed on a screen. In Fig. 10, a menu 109 is an exclusive menu for switching over the menus initially displayed to the menus displayed next. Comparing the structure with the conventional function tree structure shown in Fig. 12, in the conventional structure which has a great number of operation menus on the same hierarchy as shown in Fig. 12, the menus to be even on the same hierarchy are divided into a group on the upper-order hierarchy and a group on the low-order hierarchy as shown in the menu 13, and each group of menus has fixed members. In the third embodiment, on the contrary, the menus are considered to be on the same hierarchy, and the operational frequency of the same level is applied to the menus, so that which group a menu belongs to in Fig. 10 changes dynamically. That is, the menus are repositioned so that a menu which has the higher operational frequency is included into the group of menus displayed initially and that a menu which has the lower operational frequency is included into the group of menus displayed next.

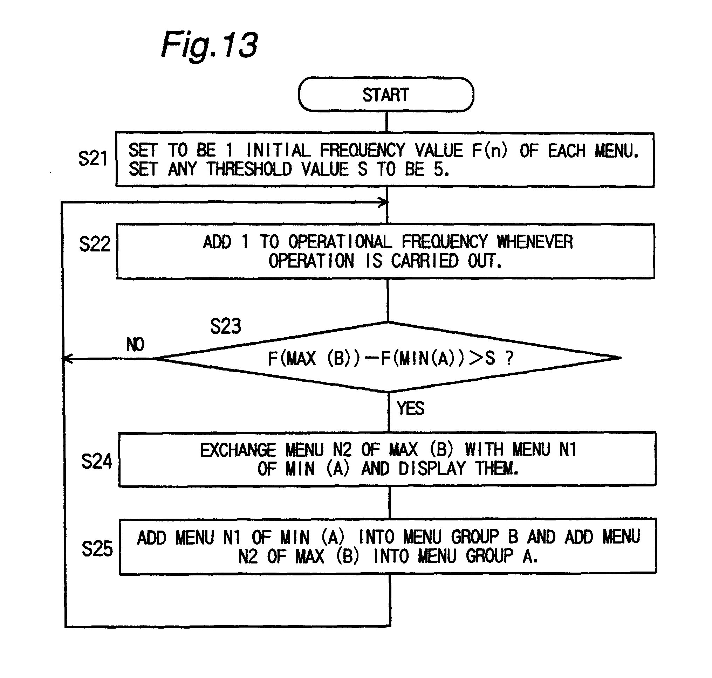

Next, in order to clearly describe the fourth embodiment, an example will be described with reference to Figs. 13 through 16.

In Fig. 13, an initial frequency value F(n) of each menu is set to be 1 at step S21 and it is assumed that any threshold value S is set to be 5. Then, each time the operation is selected and carried out, 1 is added to the operational frequency of the selected operation at step S22. Then, it is decided at step S23 whether or not F(MAX(B)) - F(MAX(A)) > S. If no, the program returns to step S22. If so, the menu N2 of the MAX(B) in the menu group B is exchanged with the menu N1 of MIN(A) in the menu group A and they are displayed in the screen. Then, the menu N1 of MIN(A) which was in the menu group A is added into the menu group B whereas the menu N2 of MAX(B) which was in the menu group B is added into the menu group A at step S25 and then, the program returns to step S22. Here, MIN(A) indicates a menu having the minimum operational frequency in the menu group A. MAX(B) indicates a menu having the maximum operational frequency in the menu group B. F(MIN(A)) indicates an operational frequency value of the menu having the minimum operational frequency in the menu group A. F(MAX(B)) indicates an operational frequency value of the menu having the maximum operational frequency in the menu group B.

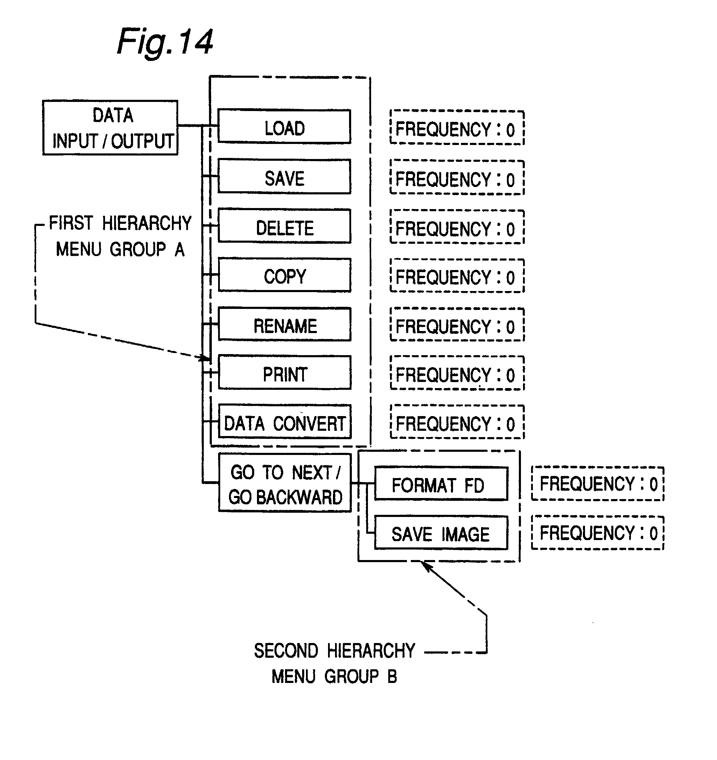

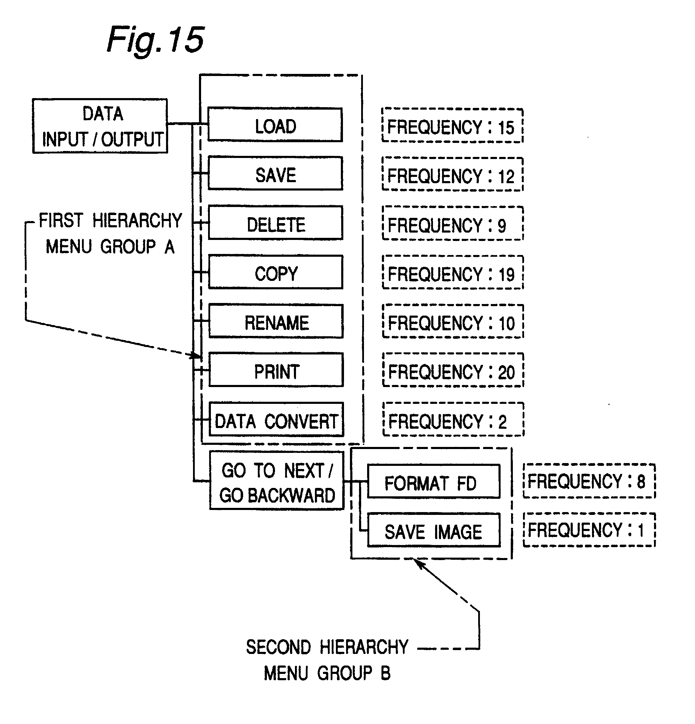

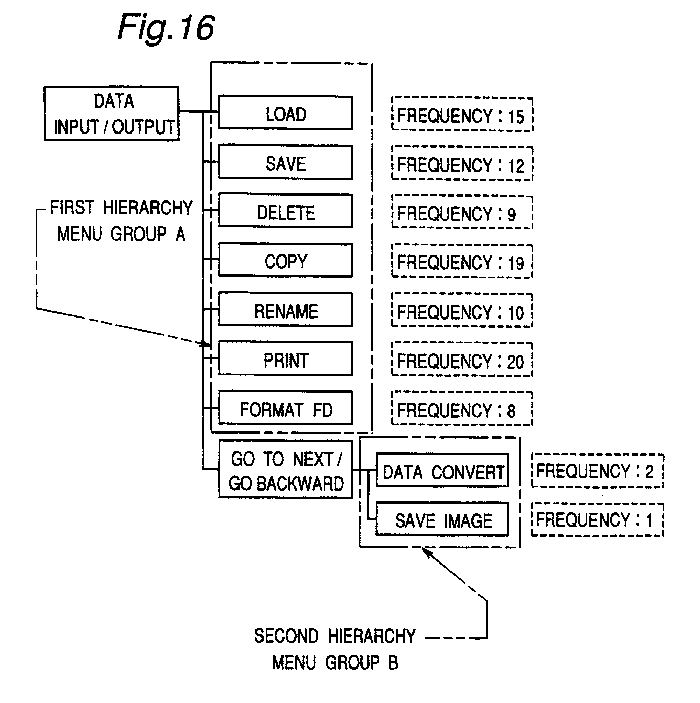

This action is shown in Figs. 14-16 as a more specific example, Fig. 14 shows a tree structure of an initial setting state of the menu screen immediately after the apparatus is turned on. An operational frequency of each menu is set to be 0. The menu group A at the first hierarchy includes LOAD, SAVE, DELETE, COPY, RENAME, PRINT, and DATA CONVERT. The menu group B at the second hierarchy includes FORMAT FD and SAVE IMAGE. In Fig. 14, when the operation of FORMAT FD is carried out, the menu of FORMAT FD can be displayed and selected after a menu of GO TO NEXT/GO BACKWARD is selected. Fig. 15 shows the screen after some operations are selected and carried out. The operational frequencies of the carried-out operations are indicated in the figure by dotted frames which are not viewed in the actual screen. The operational frequencies are increased each time the operation is carried out at step S22. In Fig. 14, MIN(A) indicating a menu having the minimum operational frequency in the menu group A is DATA CONVERT. MAX(B) indicating a menu having the maximum operational frequency in the menu group B is FORMAT FD. F(MIN(A)) indicating an operational frequency value of the menu having the minimum operational frequency in the menu group A is 2. F(MAX(B)) indicating an operational frequency value of the menu having the maximum operational frequency in the menu group B is 8. According to the operation at step S23, {F(MAX(B)) - F(MAX(A)) > S} = 8-2 = 6 > 5. Then, as shown in Figs. 15 and 15, the menu of DATA CONVERT which was in the menu group A is exchanged with the menu of FORMAT FD which was in the menu group B, and then the menu of DATA CONVERT is added in the menu group B whereas the menu of FORMAT FD is added in the menu group A. Thus, in Fig. 16, when the operation of FORMAT FD is carried out, the menu of FORMAT FD can be already displayed and easily selected without selecting the menu of GO TO NEXT/GO BACKWARD.

The method according to the third and fourth embodiments can carried out by the screen control means in Fig. 1 as an example.

According to the fourth embodiment, as described above, the menus which have higher operational frequencies are preferentially displayed so that a menu can be selected without considering the difference between the broader term and the narrower term.

As described above, the method of the invention for customizing operation menus of an electronic component mounting apparatus comprises a screen for displaying operation menus of the electronic component mounting apparatus to a user and an input means or input device for selecting an operation menu out of the operation menus, wherein an order in which the operation menus are displayed on the screen is dynamically rearranged according to frequencies of selection of the operation menus by the user so that an operation menu having the higher frequency of selection is moved to a position that is the easier to select. Besides, with respect to a group of menus on the same hierarchy which have a common upper-order menu, groups of menus which are preferentially displayed are dynamically reshuffled according to the number of menus that are displayed on a screen and according to the operational frequencies. By those means, the optimum arrangement of menus is maintained according to the state of the electronic component mounting apparatus and its operational management by the user. Thus, the menu purposed by the user can be found out and selected quickly out of a large number of intricate operation menus of the apparatus, by which the operability is improved.

In addition, because the operation menus which are based on the function tree provided by the manufacturer have a structure which is supposed to be customized, the operation menus can be flexibly adapted to additional new functions, special functions for individual users, or the like, by which the extensibility and maintainability as a apparatus are improved.

Referring to the drawings, a fifth embodiment of the invention will be described below.

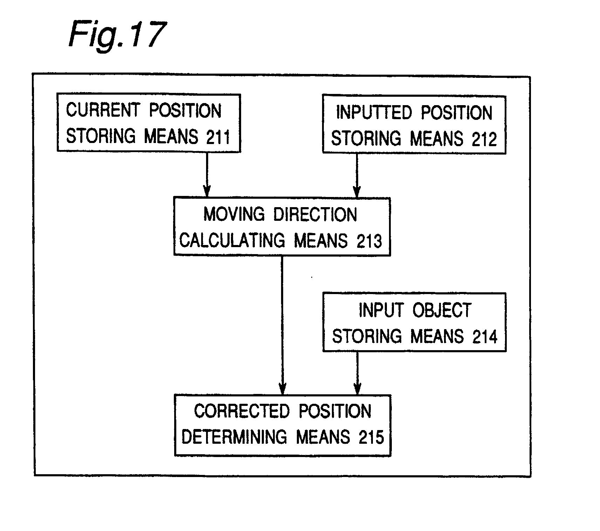

Fig. 17 is a system arrangement view of a data input method showing the fifth embodiment of the invention.

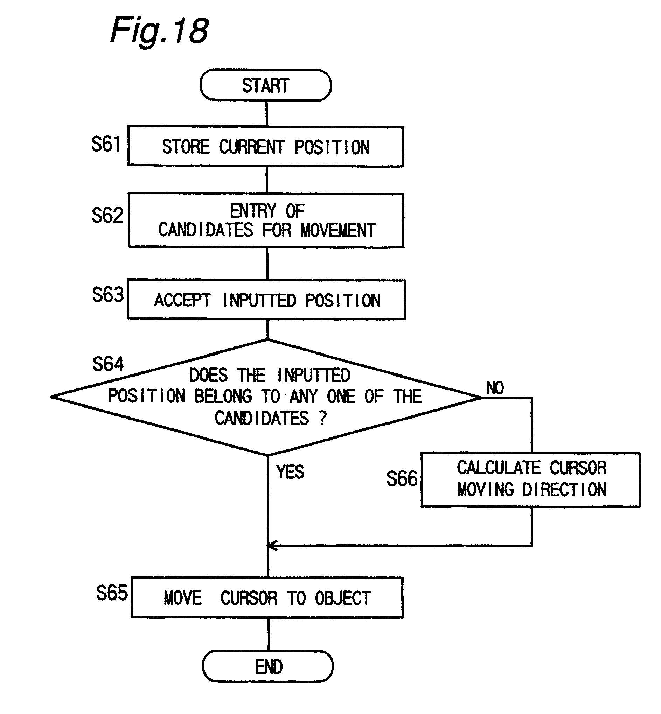

Fig. 18 is a flow chart illustrating the operation in the system arrangement of Fig. 17. Referring to Fig. 17, a current position storing means 211 stores the current cursor position at step S61, and an inputted position storing means 212 stores the cursor position inputted from an input device such as a mouse or a track ball 102 in Fig. 6 by an operator at step S63. A moving direction calculating means 213 calculates a cursor moving direction based on the current cursor position and the inputted cursor position at step S66. An input object storing means 214 stores positions of input object candidates at step S62. A corrected position determining means 215 moves the cursor to the objective position, e.g. input-waiting position, which the operator purposes, based on the calculated cursor moving direction and the positions of input object candidates at step S65.

With respect to the data input method having the above arrangement, its action is described below.

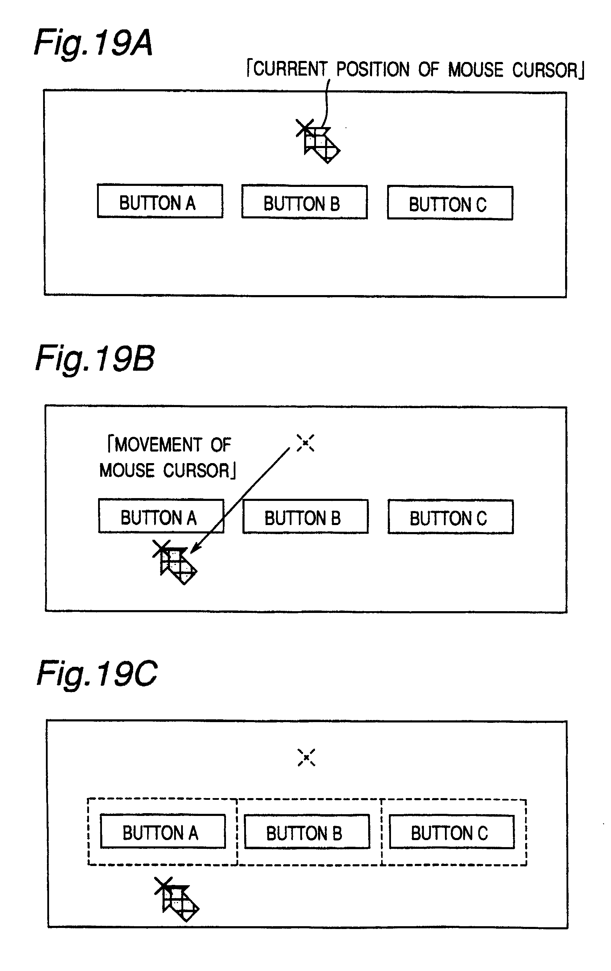

It is assumed that, as shown in Figs. 19A to 19C, there are three candidates, BUTTON A, BUTTON B, and BUTTON C, for position input to be made with the mouse, and that the current mouse cursor position is an arbitrary position. It is also assumed that each position has its coordinates as shown in the figures. The current position is stored at step S61 and the candidates for movement are stored at step S62. Assume that the operator initially moves the mouse cursor to the position shown in Fig. 19B by manipulating the mouse, where the cursor moving operation in this case is done not precisely but so roughly as to designate an approximate direction. So, the inputted position is accepted at step S63. Then, at step S64, the system calculates the cursor moving direction based on the current cursor position and the inputted cursor position. This is done by a linear equation determined from two points, y = ax + b, where "a" and "b" are constants.

On the other hand, each of the three candidates for position input is assumed to have an area with an arbitrary width, as shown by dotted lines in Fig. 19C.

With the above information, it is checked whether the position of inputted coordinates belong to any one of the areas of the three candidates for position input at step S64. If the coordinates belong to any one of the areas, the cursor is moved to reference coordinates of the objective candidate at step S65. If the coordinates belong to none of the areas, the area nearest to the linear equation, y = ax + b, of the three candidate areas for position input is found out at step S66, and then, the cursor is moved to the reference coordinates of the candidate found out at step S65.

In this process, the nearest position may be found out either by varying the constant b of the linear equation or by varying the constant a of the equation.

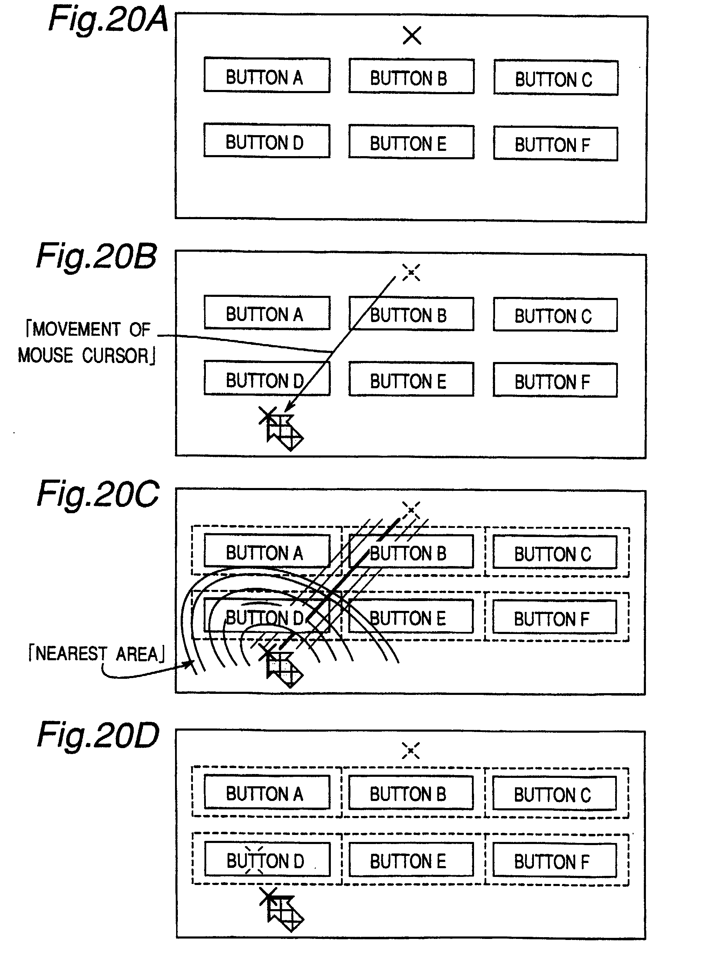

Next, it is assumed that, as shown in Figs. 20A to 20D, there are six candidates, BUTTON A, BUTTON B, BUTTON C, BUTTON D, BUTTON E, and BUTTON F, for position input to be made by the mouse, and that each position has its coordinates as shown in the figures. Now assume that the operator has moved the mouse cursor to the position shown in Fig. 20B by manipulating the mouse, where the cursor moving operation in this case is done not precisely but so roughly as to designate an approximate direction. The system calculates the cursor move direction based on the current cursor position and the inputted cursor position. This is done by a linear equation determined from two points, y = ax + b, where "a" and "b" are constants.

On the other hand, each of the six candidates for position input is assumed to have an area with an arbitrary width, as shown by dotted lines in Fig. 20C.

With the above information, it is checked whether the position of the inputted coordinates belong to any one of the areas of the six candidates for position at step S64. If the coordinates belong to any one of the areas, the cursor is moved to reference coordinates of the objective candidate at S65.

If the coordinates belong to none of the areas at step S64, the area nearest to the linear equation, y = ax + b, of the six candidate areas for position input is found out at step S66, and then, the cursor is moved to the reference coordinates of the candidate found out at step S65. In this process, if a plurality of areas have been found out as the object, the cursor is moved to reference coordinates of the candidate nearest to the position of the inputted coordinates or the candidate nearest to the position of the coordinates where the cursor has resided initially.

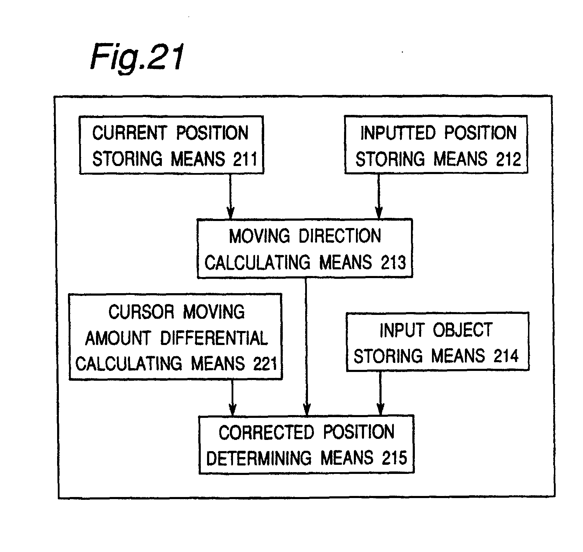

Next, a sixth embodiment of the invention is described with reference to Figs. 21 to 24.

Fig. 21 is a block diagram showing the arrangement of the sixth embodiment of the present invention. Referring to Fig. 21, the current position storing means 211 stores the current cursor position. The inputted position storing means 212 stores the cursor position inputted from an input device such as a mouse by an operator. The move direction calculating means 213 calculates a cursor moving direction based on the current cursor position and the inputted cursor position. A cursor moving amount differential calculating means 221 calculates a cursor moving velocity. The input object storing means 214 stores positions of input object candidates. The corrected position determining means 215 moves the cursor to the objective position which the operator purposes, based on the calculated cursor moving direction and the positions of the input object candidates.

With respect to the data input method having the above arrangement, its operation is described below.

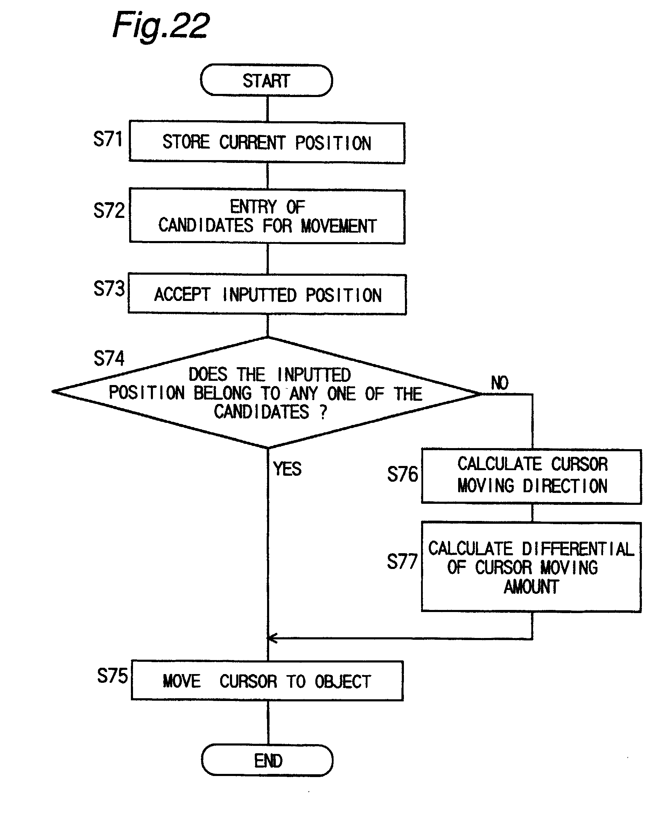

Fig. 22 is a flow chart of the operation in the arrangement of Fig. 21.

It is assumed that, as shown in Figs. 20A-20D, there are six candidates for position input to be made with the mouse, and that each position has its coordinates as shown in the figures. The current position is stored at step S71 and the candidates for movement are stored at step S72. It is also assumed that the operator has moved the mouse cursor to the position shown in Fig. 20B by manipulating the mouse, where the cursor moving operation is done not precisely but so roughly as to designate an approximate direction. So, the inputted position is stored at step S73. Then, at step S74, the system calculates the cursor moving direction based on the current cursor position and the inputted position. This is done by a linear equation determined from two points, y = ax + b, where "a" and "b" are constants. Simultaneously, the system calculates the cursor moving velocity by measuring the time which has passed since the beginning of the move of the cursor till a stop of the cursor.

In this process, the nearest position may be found out either by varying the constant b of the linear equation or by varying the constant a of the equation.

On the other hand, each of the six candidates for position input is assumed to have an area with an arbitrary width, as shown by the dotted lines in Fig. 20C.

With the above information, it is checked at step S74 whether the position of inputted coordinates belong to any one of the areas of the six candidates for position. If the coordinates belong to any one of the areas, the cursor is moved to reference coordinates of the objective candidate at step S75.

If the coordinates belong to none of the areas, the area nearest to the linear equation, y = ax + b, of the six candidate areas for position input is found out at steps S76 and S77, and then, the cursor is moved to the reference coordinates of the candidate found out at step S75. For cases where a plurality of areas have been found out as the object, cursor moving velocity is previously classified into several levels, and the cursor is moved to the position of a candidate which is determined as the object according to the level of the moving velocity. Now assume that there are three levels of moving velocity and that the cursor moving velocity is S1 corresponding to velocity level 1 (the highest velocity level). In this case, because of the high cursor move velocity, the system judges that the operator purposes the candidate that is the farther from the position of the initial coordinates, and moves the cursor to the position of the reference coordinates of BUTTON D shown in Fig. 20D. When the cursor move velocity S1 is at the velocity level 2 (medium velocity level), the system similarly moves the cursor to the position of the reference coordinates of BUTTON D. Only when the cursor move velocity S1 is at the velocity level 3 (the lowest velocity level), the system chooses the candidate that is the nearer to the position of the initial coordinates, and moves the cursor to the position of the candidate of BUTTON B.

In the above sixth embodiment, although the moving velocity has been classified into three levels, the velocity may be classified into an arbitrary number of levels. Also, for each level of the velocity, the system may choose either the candidate nearer to the position of the initial coordinates or the candidate farther from the position of the initial coordinates. whichever it is, optically.

According to the invention, as described above, in repositioning the input cursor for designation of a position by data input with an input device such as a mouse or track ball in computer operation, the cursor can be easily moved to the objective position only by a rough input of cursor position even without an input of detailed positional designation.

## Claims

1. A method for mounting components onto a member, comprising executing an operation by an operating section (4) through a monitor screen (1) in which a screen control method is used,
the screen control method comprising steps of:
providing a screen control means (2) for executing a screen saver function on the monitor screen when no operation is effected on the operating section during a preset time period;
providing an external event detecting means (3) for canceling the screen saver function upon detection of an event derived from the operating section; and
providing an internal event detecting means (6) for canceling the screen saver function upon detection of an event derived from the apparatus other than the operating section.

2. The component mounting method as defined in claim 1, wherein the event from the apparatus detected by the internal event detecting means is an error or a warning caused in executing the component mounting method.

3. The component mounting method as defined in claim 1, wherein in the screen saver function executing step, the screen saver function on the monitor screen is not executed in accordance with an operational mode of the component mounting method.

4. An apparatus for mounting components onto a member, comprising a screen control apparatus,
the screen control apparatus comprising:
a monitor screen (1);
an operating section (4) for executing an operation through the monitor screen;
a screen control means (2) for executing a screen saver function on the monitor screen;
an external event detecting means (3) for canceling the screen saver function upon detection of an event derived from the operating section; and
an internal event detecting means (6) for canceling the screen saver function upon detection of an event derived from the apparatus other than the operating section.

5. The component mounting apparatus as defined in claim 4, wherein the event from the apparatus detected by the internal event detecting means is an error or a warning caused in the apparatus.

6. The component mounting apparatus as defined in claim 4, wherein the screen control means does not execute the screen saver function on the monitor screen in accordance with an operational mode of the component mounting apparatus.

7. The component mounting method as defined in claim 1, comprising a method for customizing operation menus of an electronic component mounting apparatus comprising a screen for displaying operation menus of an electronic component mounting apparatus to a user,
the method comprising steps of:
selecting an operation menu out of the operation menus;
dynamically rearranging an order in which the operation menus are displayed on the screen, according to frequencies of selection of the operation menus by the user so that an operation menu having the higher frequency of selection is moved to a position that is easier to select.

8. The component mounting method, as defined in claim 1, comprising a method for customizing operation menus of an electronic component mounting apparatus,
the method comprising steps of:
selecting an operation menu out of the operation menus;
dynamically reshuffling, when a number of operation menus contained in a menu group of a same hierarchy which belongs to a common upper-order operation menu exceeds a maximum number of operation menus that can be displayed within a screen, groups of the operation menus according to operational frequencies of the menus so that operation menus having relatively high operational frequencies are included in a group of operation menus that is first displayed, and are thereby preferentially displayed.

9. The electronic component mounting apparatus as defined in claim 4, wherein the apparatus customizes the operation menus of the apparatus,
the apparatus further comprising an input device (102) for selecting an operation menu out of the operation menus,
wherein the screen (101) displays the operation menus, and the screen control means dynamically rearranges an order in which the operation menus are displayed on the screen, according to frequencies of selection of the operation menus so that an operation menu having the higher frequency of selection is moved to a position that is easier to select.

10. The component mounting apparatus as defined in claim 4, wherein the apparatus customizes the operation menus of the apparatus,
the apparatus further comprising an input device (102) for selecting an operation menu out of the operation menus,
wherein the screen (101) displays the operation menus, and the screen control means dynamically reshuffles, when a number of operation menus contained in a menu group of a same hierarchy which belongs to a common upper-order operation menu exceeds a maximum number of operation menus that can be displayed within the screen, groups of the operation menus according to operational frequencies of the menus so that operation menus having relatively high operational frequencies are included in a group of operation menus that is first displayed, and are thereby preferentially displayed.

11. The component mounting method as defined in claim 1, comprising a data input method for a computer using an input device,
the method comprising steps of:
in a process of repositioning an input cursor for designation of a position, storing a current cursor position and a cursor position inputted from the input device;
calculating a cursor moving direction based on both the current cursor position and the cursor position; and
moving the cursor to an input-waiting position based on the calculated cursor moving direction and positions of input object candidates, even without an input of detailed positional designation.

12. The component mounting method as defined in claim 11, further comprising a step of storing a cursor moving velocity in addition to the cursor moving direction calculated from the current cursor position and the inputted cursor position, wherein the cursor is moved to the input-waiting position based on the calculated cursor moving direction, the cursor moving velocity, and the positions of input object candidates even without an input of detailed positional designation.

13. The component mounting apparatus as defined in claim 4, further comprising:
a current position storing means (211) for storing a current cursor position;
an inputted position storing means (212) for storing a cursor position inputted from an input device;
a moving direction calculating means (213) for calculating a cursor moving direction based on both the current cursor position and the inputted cursor position;
an input object storing means (214) for storing positions of input object candidates; and
a corrected position determining means (215) for moving the cursor to an objective position which an operator purposes, based on the calculated cursor moving direction and the positions of input object candidates.

14. The component mounting apparatus as claimed in claim 13, further comprising: a cursor moving amount differential calculating means (221) for calculating a cursor moving velocity,
wherein the corrected position determining means (215) moves the cursor to the objective position which the operator purposes, based on the calculated cursor moving direction, the cursor moving velocity, and the positions of input object candidates.

## Patentansprüche

1. Verfahren zur Montage von Bauelementen auf einem Bauelementeträger, bei dem
eine Bedienhandlung an einem Bedienteil (4) mit Hilfe eines Monitorschirms (1) ausgeführt wird, in welchem ein Verfahren zur Bildschirmsteuerung angewendet wird, wobei das Verfahren zur Bildschirmsteuerung folgende Verfahrensschritte umfaßt:
Bereitstellen eines Mittels zur Bildschirmsteuerung (2), um auf dem Bildschirm eine Bildschirmschonerfunktion auszuführen, wenn während einer vorgegebenen Zeitspanne keine Bedienhandlung auf das Bedienteil einwirkt;
Bereitstellen eines Mittels zum Nachweis anlagenexterner Ereignisse (3), um die Bildschirmschonerfunktion bei Nachweis eines Ereignisses abzubrechen, das seinen Ursprung im Bedienteil hat; und
Bereitstellen eines Mittels zum Nachweis anlageninterner Ereignisse (6), um die Bildschirmschonerfunktion bei Nachweis eines Ereignisses abzubrechen, das seinen Ursprung in einer anderen Einrichtung als dem Bedienteil hat.

2. Verfahren zur Montage von Bauelementen nach Anspruch 1, bei dem das Ereignis, das mit Hilfe des Mittels zum Nachweis anlageninterner Ereignisse nachgewiesen wurde, ein Fehler- oder Warnsignal ist, das im Ablauf des Verfahrens zur Montage von Bauelementen verursacht wurde.

3. Verfahren zur Montage von Bauelementen nach Anspruch 1, in welchem die Bildschirmschonerfunktion in Abhängigkeit von der Betriebsart des Bauelemente-Montageverfahrens, innerhalb des Verfahrensschrittes, der die Bildschirmschonerfunktion bewirkt, auf dem Bildschirm nicht ausgeführt wird.

4. Bauelemente-Montageeinrichtung auf einem Bauelementeträger, mit einer Bildschirmsteuereinrichtung, wobei die Bildschirmsteuereinrichtung umfaßt:
einen Monitorschirm (1);
ein Bedienteil (4) zum Ausführen einer Bedienhandlung mit Hilfe des Monitorschirms;
ein Mittel zur Bildschirmsteuerung (2), um auf dem Monitorschirm eine Bildschirmschonerfunktion auszuführen;
ein Mittel zum Nachweis anlagenexterner Ereignisse (3), um die Bildschirmschonerfunktion bei Nachweis eines Ereignisses abzubrechen, das seinen Ursprung im Bedienteil hat; und
ein Mittel zum Nachweis anlageninterner Ereignisse (6), um die Bildschirmschonerfunktion bei Nachweis eines Ereignisses abzubrechen, das seinen Ursprung in einer anderen Einrichtung als dem Bedienteil hat.

5. Bauelemente-Montageeinrichtung nach Anspruch 4, bei der das Ereignis, das durch das Mittel zum Nachweis anlageninterner Ereignisse nachgewiesen wurde, ein Fehler- oder Warnsignal ist, das innerhalb der Einrichtung verursacht wurde.

6. Bauelemente-Montageeinrichtung nach Anspruch 4, bei der das Mittel zur Bildschirmsteuerung in einer entsprechenden Betriebsart der Bauelemente-Montageeinrichtung die Bildschirmschonerfunktion auf dem Bildschirm nicht ausführt.

7. Verfahren zur Montage von Bauelementen nach Anspruch 1, mit einem Verfahren zur kundenspezifischen Anpassung der Bedienmenüs einer Bauelemente-Montageeinrichtung, mit einem Bildschirm zum Anzeigen von Bedienmenüs einer Bauelemente-Montageeinrichtung, wobei das Verfahren folgende Schritte umfaßt:
Auswahl eines Bedienmenüs aus der Gesamtheit der Bedienmenüs;
dynamische Reorganisation einer Reihenfolge, in der die Bedienmenüs auf dem Bildschirm dargestellt werden, entsprechend der Häufigkeit der Auswahl der Bedienmenüs durch den Benutzer, so daß ein Bedienmenü, das häufiger ausgewählt wird, in eine einfacher auszuwählende Position verschoben wird.

8. Verfahren zur Montage von Bauelementen nach Anspruch 1, mit einem Verfahren zur kundenspezifischen Anpassung der Bedienmenüs einer Bauelemente-Montageeinrichtung, wobei das Verfahren folgende Schritte umfaßt:
Auswahl eines Bedienmenüs aus der Gesamtheit der Bedienmenüs;
dynamisches Umgruppieren von Bedienmenügruppen entsprechend der betriebsbedingten Auswahlhäufigkeiten der Menüs, wenn innerhalb einer Menügruppe gleicher Rangordnung eine Anzahl von Bedienmenüs, die zu einem gemeinsamen Bedienmenü einer höheren Rangordnung gehören, eine auf einem Bildschirm darstellbare maximale Anzahl von Bedienmenüs übersteigt, so daß Bedienmenüs mit relativ hoher betriebsbedingter Auswahlhäufigkeit in einer Gruppe von Bedienmenüs zusammengefaßt werden, die zuerst angezeigt und somit vorzugsweise dargestellt wird.

9. Bauelemente-Montageeinrichtung nach Anspruch 4, bei der durch die Einrichtung selbst eine kundenspezifische Anpassung der Bedienmenüs der Einrichtung bewirkt wird, wobei
die Einrichtung weiterhin ein Eingabegerät (102) zur Auswahl eines Bedienmenüs aus der Gesamtheit der Bedienmenüs enthält,
die Bedienmenüs auf dem Bildschirm (101) dargestellt werden und die Mittel zur Bildschirmsteuerung die Reihenfolge, in der die Bedienmenüs auf dem Bildschirm dargestellt werden, entsprechend der Auswahlhäufigkeit der Bedienmenüs dynamisch reorganisieren, so daß ein häufiger ausgewähltes Bedienmenü in eine einfacher auszuwählende Position verschoben wird.

10. Bauelemente-Montageeinrichtung nach Anspruch 4, bei der durch die Einrichtung selbst eine kundenspezifische Anpassung der Bedienmenüs der Einrichtung bewirkt wird,
die Einrichtung weiterhin ein Eingabegerät (102) zur Auswahl eines Bedienmenüs aus der Gesamtheit der Bedienmenüs enthält,
wobei auf dem Bildschirm (101) die Bedienmenüs dargestellt und durch die Mittel zur Bildschirmsteuerung Gruppen der Bedienmenüs entsprechend der betriebsbedingten Auswahlhäufigkeiten der Menüs dynamisch umgruppiert werden, wenn innerhalb einer Menügruppe gleicher Rangordnung eine Anzahl von Bedienmenüs, die zu einem gemeinsamen Bedienmenü einer höheren Rangordnung gehören, eine auf einem Bildschirm darstellbare maximale Anzahl von Bedienmenüs übersteigt, so daß Bedienmenüs mit relativ hoher betriebsbedingter Auswahlhäufigkeit in einer Gruppe von Bedienmenüs zusammengefaßt werden, die zuerst angezeigt und somit vorzugsweise dargestellt wird.

11. Verfahren zur Montage von Bauelementen nach Anspruch 1, mit einem Verfahren zur Eingabe von Daten in einen Computer unter Verwendung eines Eingabegerätes, wobei das Verfahren folgende Verfahrensschritte umfaßt:
Speichern einer aktuellen und einer über das Eingabegerät eingegebenen Cursorposition im Prozeß der Umpositionierung eines Eingabecursors zur Bezeichnung einer Position;
Berechnen einer Bewegungsrichtung des Cursors auf Grundlage sowohl der aktuellen als auch der eingegebenen Cursorposition; und
Verschieben des Cursors in eine, auf der berechneten Bewegungsrichtung des Cursors und den Positionen potentieller Eingabeziele basierende Eingabe-Warteposition, sogar ohne Eingabe einer genauen Positionsbezeichnung.

12. Verfahren zur Montage von Bauelementen nach Anspruch 11, das einen weiteren Verfahrensschritt einschließt, in welchem zusätzlich zur Bewegungsrichtung des Cursors, die aus der aktuellen Cursorposition und der eingegebenen Cursorposition berechnet wurde, eine Bewegungsgeschwindigkeit des Cursors gespeichert wird, wobei der Cursor auf Basis der berechneten Bewegungsrichtung des Cursors, der Bewegungsgeschwindigkeit des Cursors und der Positionen der potentiellen Eingabeziele sogar ohne Eingabe einer genauen Positionsbezeichnung in die Eingabe-Warteposition verschoben wird.

13. Bauelemente-Montageeinrichtung nach Anspruch 4, mit:
einem Mittel zur Speicherung einer aktuellen Cursorposition (211);
einem Mittel zur Speicherung einer eingegebenen Position (212), um eine Cursorposition zu speichern, die über ein Eingabegerät eingegeben wurde;
einem Mittel zur Berechnung der Bewegungsrichtung (213), um die Bewegungsrichtung eines Cursors sowohl auf Basis der aktuellen als auch der eingegebenen Cursorposition zu berechnen;
einem Mittel zur Eingabezielspeicherung (214), um die Positionen potentieller Eingabeziele zu speichern; und
einem Mittel zur Bestimmung der korrigierten Position (215), um den Cursor auf Basis der berechneten Bewegungsrichtung des Cursors und der Positionen der potentiellen Eingabeziele in eine vom Bediener gewünschte Zielposition zu verschieben.

14. Bauelemente-Montageeinrichtung nach Anspruch 13, die weiterhin enthält: ein Mittel zur Berechnung der eigenrelativen Cursorverschiebung (221), um eine Bewegungsgeschwindigkeit eines Cursors zu berechnen, wobei das Mittel zur Bestimmung der korrigierten Position (215) den Cursor auf Basis der berechneten Bewegungsrichtung des Cursors, der Bewegungsgeschwindigkeit des Cursors und der Positionen der potentiellen Eingabeziele in eine vom Bediener gewünschte Zielposition verschiebt.

## Revendications

1. Méthode de montage de composants sur un élément, comportant l'exécution d'une opération par une section d'opération (4) au travers d'un écran de contrôle (1) dans lequel une méthode de contrôle d'écran est utilisée, la méthode de contrôle de l'écran comportant les étapes de:
établissement d'un moyen de contrôle d'écran (2) pour exécuter une fonction-économiseur d'écran sur l'écran de contrôle lorsqu'aucune opération n'est effectuée sur la section d'opération durant une période de temps préétablie;
établissement d'un moyen de détection d'évènements externes (3) pour annuler la fonction-économiseur d'écran à la détection d'un événement provenant de la section d'opération; et
établissement d'un moyen de détection d'évènements internes (6) pour annuler la fonction économiseur d'écran à la détection d'un événement provenant d'un dispositif autre que la section d'opération.

2. Méthode de montage de composants telle que définie dans la revendication 1, dans laquelle l'événement à partir du dispositif détecté par le moyen de détection d'évènements interne, est une erreur ou une alarme provoquée dans l'exécution de la méthode de montage de composants.

3. Méthode de montage de composants telle que définie dans la revendication 1, dans laquelle, dans l'étape d'exécution de la fonction économiseur d'écran, la fonction économiseur d'écran sur l'écran de contrôle n'est pas exécutée conformément à un mode opératoire de la méthode de montage de composants.

4. Appareil de montage de composants sur un élément, comportant un appareil de contrôle d'écran, l'appareil de contrôle d'écran comportant:
un écran de contrôle (1);
une section d'opération (4) pour exécuter une opération au travers de l'écran de contrôle;
un moyen de contrôle d'écran (2) pour exécuter une fonction économiseur d'écran sur l'écran de contrôle;
un moyen de détection d'évènements externes (3) pour annuler la fonction économiseur d'écran à la détection d'un événement provenant de la section d'opération; et
un moyen de détection d'évènement interne (6) pour annuler la fonction économiseur d'écran à la détection d'un événement déduit de l'appareil, autre que de la section d'opération.

5. Appareil de montage de composants, tel que défini dans la revendication 4, dans lequel l'événement à partir de l'appareil, détecté par le moyen de détection d'événement interne, est une erreur ou une alarme provoquée dans l'appareil.

6. Appareil de montage de composants, tel que défini dans la revendication 4, dans lequel le moyen de contrôle d'écran n'exécute pas la fonction économiseur d'écran sur l'écran de contrôle conformément à un mode opératoire de l'appareil de montage de composants.

7. Méthode de montage de composants, telle que définie dans la revendication 1, comportant une méthode de personnalisation de menus de fonctionnement d'un appareil de montage de composants électroniques comportant un écran pour afficher des menus de fonctionnement d'un appareil de montage de composants électroniques, destinés à un utilisateur, la méthode comportant les étapes de:
sélection d'un menu de fonctionnement parmi les menus de fonctionnement;
réarrangement dynamique d'un ordre dans lequel les menus de fonctionnement sont affichés sur l'écran, selon les fréquences de sélection des menus de fonctionnement par l'utilisateur afin qu'un menu de fonctionnement ayant la fréquence de sélection la plus haute, soit déplacé à une position qui soit plus facile à sélectionner.

8. Méthode de montage de composants, telle que définie dans la revendication 1, comportant une méthode de personnalisation de menus de fonctionnement d'un appareil de montage de composants électroniques, la méthode comportant les étapes de:
sélection d'un menu de fonctionnement parmi les menus de fonctionnement;
remaniement dynamique, lorsqu'un nombre de menus de fonctionnement contenus dans un groupe de menus d'une même hiérarchie qui appartient à un menu de fonctionnement d'ordre supérieur commun, excède un nombre maximum de menus de fonctionnement qui peuvent être affichés dans un écran, les groupes de menus de fonctionnement selon les fréquences d'utilisation des menus de sorte que les menus de fonctionnement ayant les fréquences d'utilisation relativement hautes, sont inclus dans un groupe de menus de fonctionnement qui est affiché en premier, et sont ainsi affichés de façon préférentielle.

9. Appareil de montage de composants électroniques tel que défini dans la revendication 4, dans lequel l'appareil personnalise les menus de fonctionnement de l'appareil, l'appareil comportant de plus un dispositif d'entré (102) pour sélectionner un menu de fonctionnement parmi les menus de fonctionnement,
dans lequel l'écran (101) affiche les menus de fonctionnement, et le moyen de contrôle d'écran réarrange de façon dynamique un ordre dans lequel les menus de fonctionnement sont affichés sur l'écran, selon les fréquences de sélection des menus de fonctionnement afin qu'un menu de fonctionnement ayant la fréquence de sélection la plus haute, soit déplacé à une position qui est plus facile à sélectionner.

10. Appareil de montage de composants, tel que défini dans la revendication 4, dans lequel l'appareil personnalise les menus de fonctionnement de l'appareil, l'appareil comportant en outre un dispositif d'entré (102) pour sélectionner un menu de fonctionnement parmi les menus de fonctionnement,
dans lequel l'écran (101) affiche les menus de fonctionnement, et le moyen de contrôle d'écran remanie de façon dynamique, lorsqu'un nombre de menus de fonctionnement contenus dans un groupe de menus d'une même hiérarchie qui appartient à un menu de fonctionnement d'ordre supérieur commun, excède un nombre maximum de menus de fonctionnement qui peuvent être affichés dans l'écran, les groupes de menus de fonctionnement selon les fréquences d'utilisation des menus afin que les menus de fonctionnement ayant des fréquences d'utilisation relativement hautes, soient inclus dans un groupe de menus de fonctionnement qui est affiché en premier, et sont ainsi affichés de façon préférentielle.

11. Méthode de montage de composants, telle que définie dans la revendication 1, comportant une méthode d'entrée de données pour un ordinateur utilisant un dispositif d'entrée, la méthode comportant les étapes de:
stockage d'une position courante de curseur et d'une position de curseur entrée à partir du dispositif d'entrée, dans un procédé de repositionnement d'un curseur d'entrée pour la désignation d'une position;
calcul d'une direction de déplacement de curseur sur la base à la fois de la position courante du curseur et à la fois de la position du curseur; et
déplacement du curseur vers une position d'attente d'entrée sur la base de la direction de déplacement du curseur calculée et des positions des candidats d'objets entrés, même sans une entrée de la désignation détaillée de la position.

12. Méthode de montage de composants, telle que définie dans la revendication 11, comportant en outre une étape de stockage d'une vitesse de déplacement de curseur en addition à la direction de déplacement de curseur calculée à partir de la position courante du curseur et de la position entrée du curseur, dans laquelle, le curseur est déplacé vers la position d'attente d'entrée sur la base de la direction de déplacement de curseur calculée, de la vitesse de déplacement de curseur, et des positions des candidats d'objet d'entrée même sans une entrée de la désignation détaillée de la position.

13. Appareil de montage de composants tel que défini dans la revendication 4, comportant en outre:
un moyen de stockage de position courante (211) pour stocker une position courante de curseur;
un moyen de stockage de position entrée (212) pour stocker une position de curseur entrée à partir d'un dispositif d'entrée;
un moyen de calcul de direction de déplacement (213) pour calculer une direction de déplacement de curseur sur la base à la fois de la position courante du curseur, et à la fois de la position du curseur entrée;
un moyen de stockage d'objet d'entrée (214) pour stocker des positions de candidats d'objet d'entrée; et
un moyen de détermination de position corrigée (215) pour déplacer le curseur vers une position objective qu'un opérateur vise, sur la base de la direction de déplacement du curseur calculée, et des positions des candidats d'objet d'entrée.

14. Appareil de montage de composants, selon la revendication 13, comportant en outre: un moyen de calcul différentiel de quantité de déplacement de curseur (221) pour calculer une vitesse de déplacement de curseur,
dans lequel le moyen de détermination de la position corrigée (215) déplace le curseur vers la position objective que l'opérateur vise, sur la base de la direction de déplacement du curseur calculée, de la vitesse de déplacement du curseur, et des positions des candidats d'objet d'entrée.
